Europäisches Patentamt

**European Patent Office**

**Office européen des brevets**

(19)

(11) Publication number: **0 075 028**
**A1**

## EUROPEAN PATENT APPLICATION

(12)

published in accordance with Art. 158(3) EPC

(21) Application number: **82901006.5**

(22) Date of filing: **02.04.82**

Data of the international application taken as a basis:

(86) International application number:
**PCT/JP 82/00100**

(87) International publication number:
**WO 82/03471 (14.10.82 82/25)**

(51) Int. Cl.³: **G 03 F 7/00, G 03 D 5/04**

(30) Priority: **04.04.81 JP 49077/81 U**
**04.04.81 JP 49078/81 U**

(43) Date of publication of application: **30.03.83**
**Bulletin 83/13**

(84) Designated Contracting States: **DE FR GB**

(71) Applicant: **KONISHIROKU PHOTO INDUSTRY CO. LTD.,**
**No. 26-2, Nishishinjuku 1-chome Shinjuku-ku,**
**Tokyo 160 (JP)**

(72) Inventor: **AOKI, Kazushige, 20-13,**
**Ohwada-machi 6-chome, Hachioji-shi Tokyo 192 (JP)**
Inventor: **YOSHIDA, Masayoshi, 1460, Tsuzido**
**Fuzisawa-shi, Kanagawa 251 (JP)**

(74) Representative: **Ben-Nathan, Laurence Albert et al, c/o**
**MICHAEL BURNSIDE & PARTNERS 2 Serjeants' Inn**
**Fleet Street, London EC4Y 1HL (GB)**

(54) **APPARATUS FOR TREATING LITHOGRAPHIC PRINTING BLOCKS.**

(57) Lithographic printing block treatment apparatus in which circulating washing water (6) is ejected against both surfaces of a printing block (7) to be treated as it is fed to a desensitizer treatment tank (3) through an alkaline development tank (1) in a circulating washing tank (5) to wash the printing block. Treatment liquids (2), (4) and (6) are supplied from interchangeable storage tanks (42), (26) and (56) respectively to the tanks (1), (3) and (5), and the residues in the tanks (1), (3) and (5) are reduced to the tanks (42), (26) and (56) respectively.

0075028

Description   ~~TITLE MODIFIED~~
~~see front page~~

PLANOGRAPHIC PRINTING PLATE TREATMENT DEVICE

Technical Field

The present invention relates to a planographic printing plate treatment device in which the printing plate is developed by alkaline developer solution and washed with circulating water and then treated with a desensitizer such as gum or rinse solution.

Background Art

In one of the currently available planographic printing plate treatment devices, the printing plate is treated with a desensitizer immediately after being developed by alkaline developer. In such devices the amount of developer solution that still attaches to the printing plate even after squeeze-out operation and is carried over from the development tank to the desensitizing tank, is required to be as small as 2 ml/m$^2$. This is because the large amount of developer carried over results not only in a shorter life of a second treatment solution or desensitizer but also in the formation of stains on the printing plate deteriorating the commercial value of the printed matter.

To keep the amount of developer carried over as small as possible, the conventional device uses squeeze rollers with very high machining accuracy and there are strict requirements on the squeeze rollers such as rubber material, hardness, surface machining accuracy and compression strength. This inevitably makes the squeeze rollers expensive and it is necessary to keep the surface of the rollers clean by the daily maintenance to maintain high accuracy of the rollers. Should there be any small scores found, the rollers must be replaced immediately and this pushes up the maintenance cost substantially.

As described above, the conventional device has the drawbacks of requiring huge cost in maintaining the squeeze rollers and of not being able to extend the desensitizer life and make full use of it.

In the conventional planographic printing plate treating device the reservoir containing the treatment solution is usually installed below the treatment tank and, when there is no treatment solution reservoir, the treatment tank serves as the reservoir. With this construction the replacement of the treatment solutions and the washing of the treatment tanks are not easy, requiring many hours. Especially with the device having no developer resupply tank, there is a limit on the capacity

- 3 -

0075028

of treating the printing plate. The treatment of 60 to 70 $m^2$ of printing plate with 20 liter of developer solution, i.e., the treatment of 43 to 50 A-size plates requires replacement of the developer solution, so that the developer solution must be replaced normally once a day or, when a large amount of plates are processed, twice a day. Further it is necessary to lay waste fluid piping. To alleviate these problems, it is a common practice to increase the treating capacity by increasing the volume of the reservoir containing the developer solution and to reduce the feeding speed of the printing plate to elongate the developing process time so as to increase the amount of treatment. However, the former practice produces another new problem that the treatment device becomes large in size requiring a larger installation space and the latter results in longer process time reducing the process efficiency. In other words these practices do not solve the problems inherent to the conventional devices.

## Disclosure of the Invention

Accomplished in the light of the above mentioned drawbacks, the present invention has an object to overcome these drawbacks by providing a washing tank between the alkaline development tank and the desensitizing tank and by spraying circulating water against both sides of the printing plate in the washing tank to clean the plate surfaces.

Another object of this invention is to make easy the replacement of treatment solution and the cleaning of treatment tanks and obviate the necessity to lay waste fluid piping by supplying treatment solution from the replaceable reservoir provided outside the treatment tank and by returning the used treatment solution to the reservoir.

### Brief Description of Drawings

Figure 1 is a cross section showing one embodiment of a device for treating the planographic printing plate according to this invention;

Figure 2 is a perspective view showing the essential part of the printing plate treating device as illustrated in Figure 1;

Figures 3 and 4 are perspective views showing the essential part of other embodiments;

Figure 5 is a cross section showing another embodiment of a device for treating the planographic printing plate according to this invention;

Figure 6 is a cross section showing still another embodiment; and

Figures 7 and 8 are cross sections of other forms of reservoirs.

### Best Mode for Carrying out the Invention

The present invention will now be described with reference to the accompanying drawings.

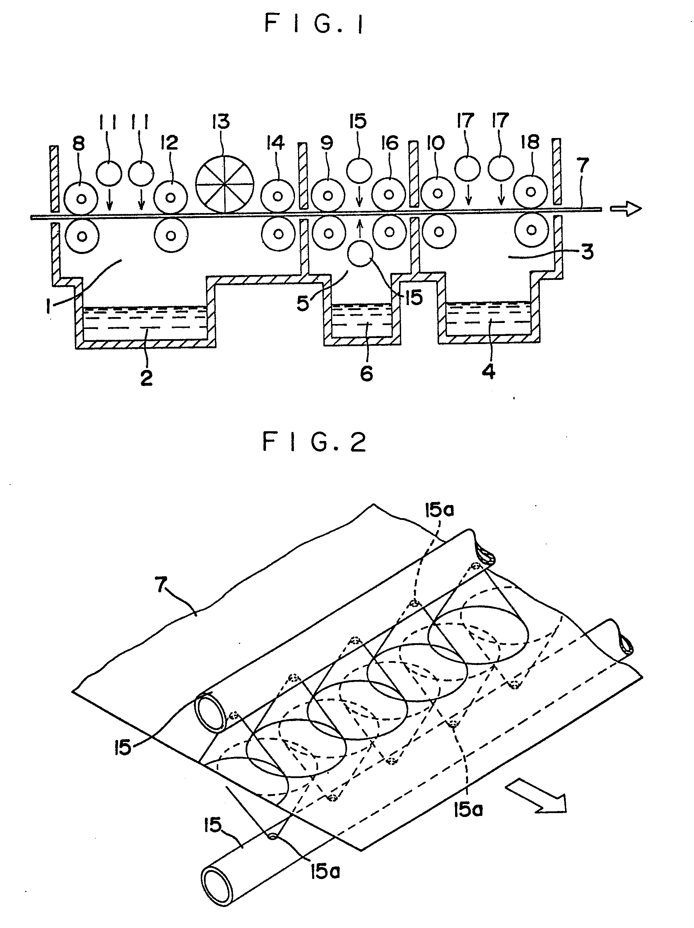

Figure 1 is a cross section showing one embodiment

0075028

of the planographic printing plate treating device according to the invention and Figure 2 is a perspective view showing the essential part of the device washing the printing plate. In these figures, denoted 1 is an alkaline development treatment tank, in the lower portion of which a developer solution 2 is stored. Reference numeral 3 signifies a desensitizer treatment tank, in the lower part of which a desensitizer solution 4 such as gum solution or rinse solution is collected. Designated 5 is a circulating water washing tank provided between the development tank 1 and the desensitizing tank 3 and in the lower part of the washing tank a circulating water 6 is stored. 7 is a printing plate which is fed between rollers 8, 9, 10 installed in the development tank 1, washing tank 5 and desensitizing tank respectively. Installed inside the development tank 1, in addition to the rollers 8, are spray pipes 11 for blowing a developer solution 2 against the upper surface of the printing plate 7, feeder rollers 12 for supporting the printing plate 7 at the center of the tank 1, a brush roller 13 placed in contact with the upper surface of the printing plate 7, and squeeze rollers 14 for removing developer solution 2 from the printing plate 7. Inside the washing tank 5 are installed spray pipes 15 for jetting water against both sides of the plate 7 and squeeze rollers 16 for removing water 6 from the plate 7. Provided inside the desensitizing tank 3 are spray pipes 17 for blowing a desensitizer 4 against the upper surface of the printing plate 7 and squeeze rollers 18 for removing the desensitizer from the plate surface. The spray pipes 15 have holes 15a cut at predetermined intervals on the side facing the printing plate 7 so that water is splashed against the plate through these holes as shown in Figure 2. Means such as pumps for supplying the treating solutions 2, 4 and water 6 from the tanks 1, 3, 5 to the pipes 11, 17, 15 are not shown.

In the following the operation of the device of this invention with the above construction will be explained. As the printing plate 7 is fed into the first tank or the development tank 1 by the rollers 8, the developer solution 2 is sprayed against the plate 7 and the development process is facilitated by the brush roller 13, after which the development solution 2 is removed from the plate by the squeeze rollers 14. The plate 7 is then fed into the second tank or the washing tank 5 where the plate 7 is washed by circulating water 6 that is sprayed against each side of the plate 7, and it is removed of water 6 by the squeeze rollers 16. As the plate 7 moves into the third tank or desensitizing tank 3, the desensitizer solution 4 is sprayed from the pipes 17 against the upper surface of the plate 7 and then removed from the plate 7 by the squeeze rollers 18.

In this embodiment, therefore, the development solution 2 sprayed against the printing plate 7 from the spray pipe 11 is removed by the squeeze rollers 14 and then washed away by water 6 in the washing tank 5, after which most of the water and the development solution attaching to the surfaces of the plate 7 are wiped away from the plate 7 by the squeeze rollers 16. Thus, the amount of development solution 2 that is carried over to the desensitizing tank 3 is very small making it possible to use the squeeze rollers 14, 16 with low precision. Even with the use of squeeze rollers with low machining accuracy the above embodiment can elongate the life of desensitizer 4 as compared with the conventional device. For instance, the conventional device can treat about 26 $m^2$ of the printing plate 7 with one liter of desensitizer, while the above construction enables the treatment of 100 $m^2$ per liter about four times the capacity of the conventional device.

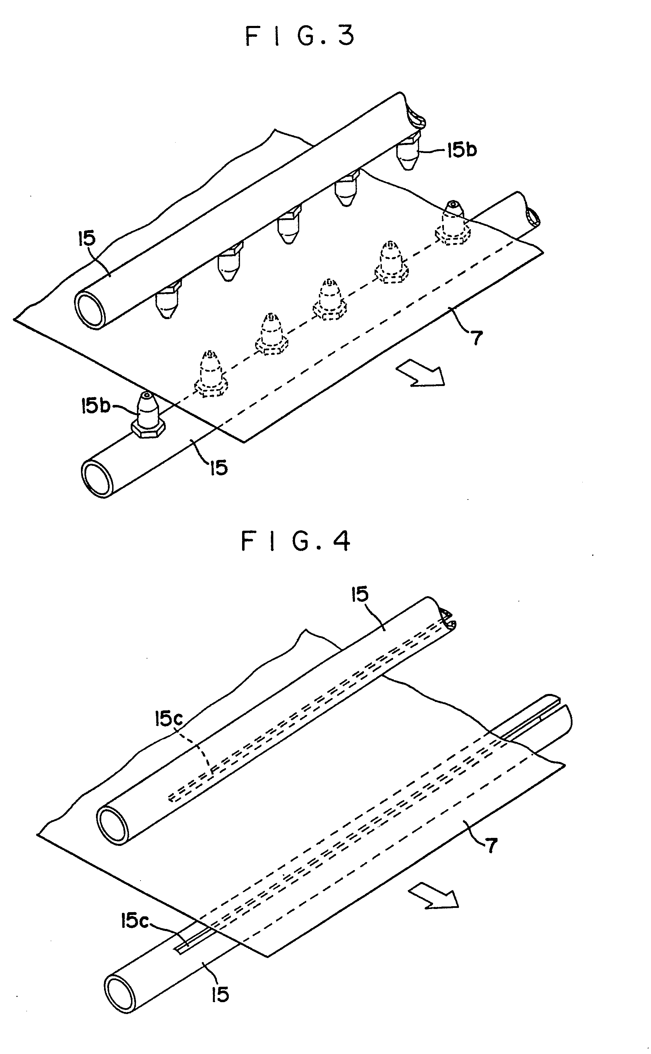

While in the above embodiment both the upper and lower surfaces of the printing plate 7 are washed with water sprayed from the pipes 15, only the upper surface may be washed. It is, however, desirable to wash the both sides of the plate in increasing the life of desensitizer since the developer solution attaches also to the underside of the plate 7. In the above embodiment circular holes 15a are cut in the spray pipes 15. It is also possible, as shown in Figure 3, to provide needle type nozzles 15b to the spray pipes 15 through which to spray water against the plate 7, or as shown in Figure 4 a slit 15c may be formed in the spray pipes 15. Further, the intervals between circular holes 15a or nozzles 15b and the width of the slit 15c may be changed to make the amount of water sprayed uniform over the entire span of pipe 15. While the treatment tanks 1, 3, 5 double as reservoirs for storing the treatment solutions 2, 4, 6, it is possible to provide treatment solution storage reservoirs separately.

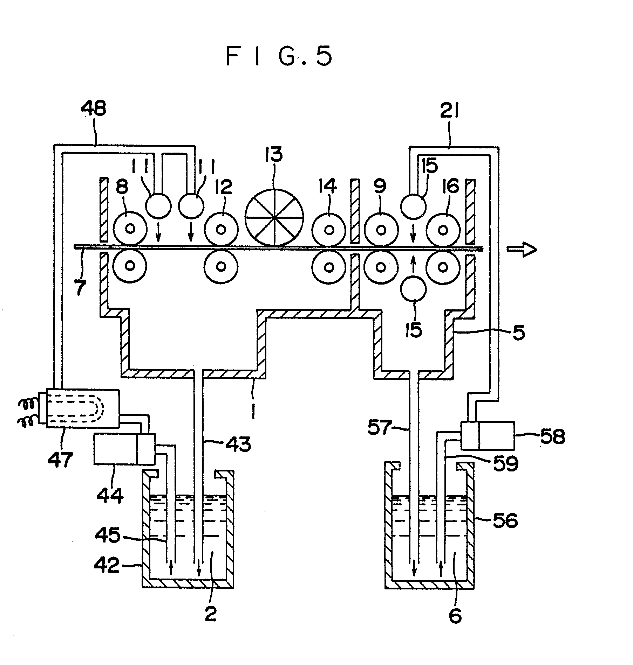

Figure 5 is a cross section of another embodiment of the planographic printing plate treatment device according to this invention. In this figure the constitutional members alike to those of the first embodiment carry like reference numerals. Installed below the developing tank 1 is a replaceable cartridge type reservoir 42 containing the developer solution. The bottom of the developing tank 1 is communicated through a return pipe 43 to the solution reservoir 42. Denoted 44 is a pump which pumps up the developer solution 2 through a suction pipe 45 and delivers it to the spray pipes 11 through a heat exchanger 47 and a delivery pipe 48. Installed below the washing tank 5 is a replaceable reservoir 56 which is connected to the lower part of the washing tank 5 through a return pipe 57. A pump 58 pumps up the washing water 6 through a suction pipe 59 and delivers it through a delivery pipe 21 to the spray pipes 15.

The plate treating process as performed by this embodiment will be explained in the following. The reservoirs 42, 56 are set so that the lower ends of the return pipes 43, 57 and the suction pipes 45, 59 are kept immersed in the solution 2 and water 6, which are circulated by the pumps 44, 58. The operation of the pump 44 causes the developer solution 2 heated by the heat exchanger 47 to be sprayed from the spray pipes 11 onto the upper surface of the planographic printing plate 7. The operation of the pump 58 pumps up the water 6 from the reservoir 56 and causes it to be sprayed from the spray pipes 15 against the upper and lower surfaces of the printing plate 7. After being sprayed with developer solution 2 the printing plate 7 is treated with the brush roller 13 to facilitate the development and is removed of the development solution 2 by the rollers 14. Then the plate 7 is fed to the washing tank 5 where it is washed by spraying water 6 and removed of water by the rollers 16 before being fed out of the treatment device.

With the above construction, the developer solution 2 and washing water 6 can be renewed by simply replacing the reservoirs 42, 56 with the ones containing new solutions. This is preferable in the light of environmental pollution because the used solutions can be disposed of simply by removing the replaceable reservoirs containing waste solutions and transferring them to subcontractors specializing in waste fluid disposal. It also has the advantage of obviating the installation of waste fluid piping and of making it possible to install the printing plate treatment device at any place desired. Furthermore, during daily maintenance, the treatment tanks 1, 5 can readily be cleaned by simply supplying water into the reservoirs 42, 56 and circulating it by running pumps.

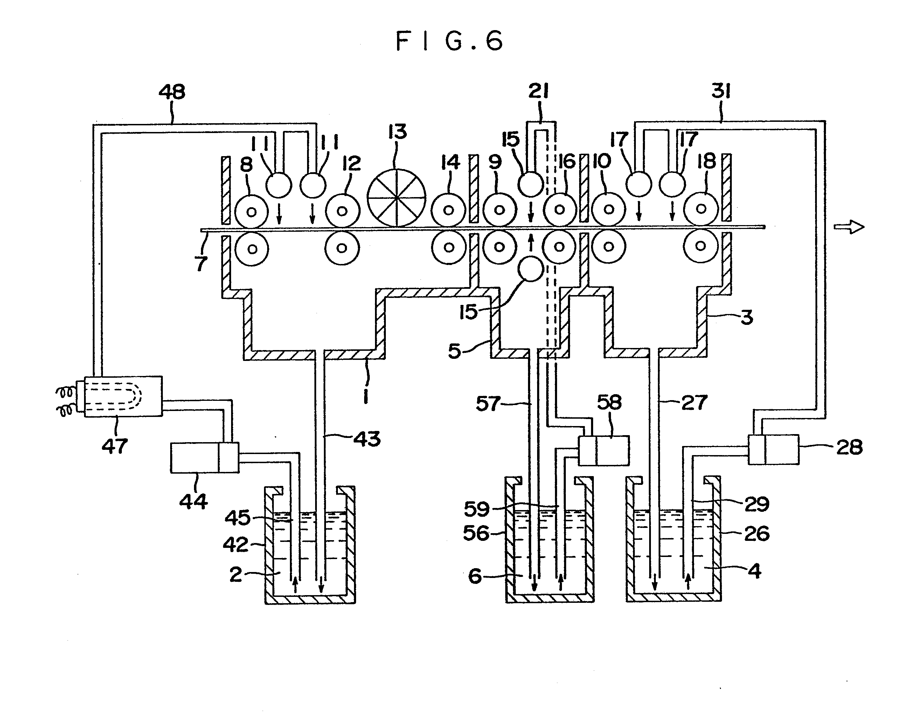

Figure 6 represents still another embodiment of this invention which has a third treatment tank where the printing plate 7, after being developed and washed, is stabilized with desensitizer such as gum or rinse solution. The difference between this and the treatment device of Figure 5 lies in the provision of the desensitizing tank 3 subsequent to the washing tank 5. A replaceable reservoir 26 is installed below the desensitizing tank 3, the lower part of which is connected through a return pipe 27 to the reservoir 26. A pump 28 pumps up the desensitizer solution 4 via a suction pipe 29 to send it through a delivery pipe 31 to the spray pipes 17. The treating process at the desensitizing tank 3 is similar to that of other tanks. That is, as the printing plate 7 is fed from the washing tank 5, the pump 28 causes the desensitizer solution 4 to be sprayed from the spray pipes 17 against the upper surface of the plate 7 which is then removed of desensitizer 4 by the rollers 18 before being fed out.

The three-tank type treating device has the advantages of substantially reducing the amount of developer solution 2 carried over to the desensitizing tank thus greatly increasing the life of desensitizer 4 and also of heightening the quality of printing plate 7. The benefit of the invention that the replacement of the treatment solutions and the cleaning of the tanks can be done with ease becomes greater as the number of treatment tanks increases.

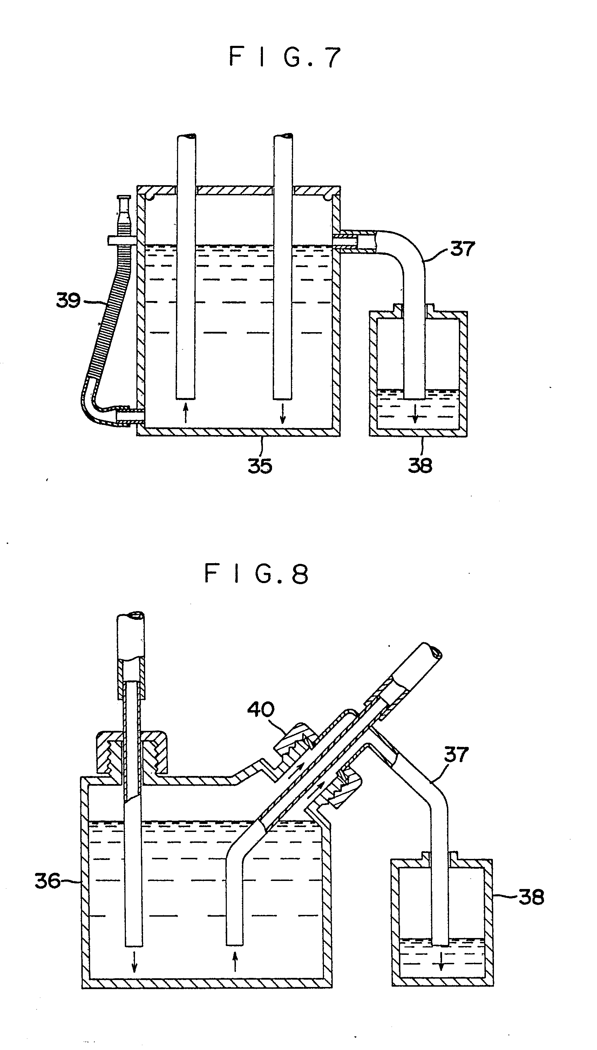

The developer solution resupply system which has come into use recently can be provided by installing a reservoir with an overflow attachment tank as shown in Figures 7 and 8. Figure 7 illustrates an open type reservoir 35 and Figure 8 a closed type reservoir 36 in which reference numeral 37 denotes an overflow pipe, 38 a used solution recovery tank, 39 a used solution pipe and 40 a tap serving as a suction and an overflow tap.

## Industrial Applicability

As explained above, the present invention obviates the necessity of using the squeeze rollers with high machining accuracy making the squeeze rollers and their maintenance cost less expensive and also increases the life of desensitizer. Furthermore, with this invention the replacement of treatment solutions and the washing of treatment tanks can be done with ease and no used solution disposal piping is needed.

0075028

## Claims

(1)   A planographic printing plate treatment device comprising: a washing tank installed between an alkaline development tank and a desensitizing tank, in which circulating water is sprayed against each side of a printing plate to wash the surfaces thereof.

(2)   A planographic printing plate treatment device, wherein treatment solution to be sprayed against a printing plate fed into a treatment tank is supplied from replaceable reservoir provided outside the treatment tank and used treatment solution in the treatment tank is recovered into the replaceable reservoir.

FIG. 1

FIG. 2

F I G. 3

F I G. 4

F I G. 5

# FIG.6

FIG.7

39

37

35        38

FIG.8

40

37

36        38

# INTERNATIONAL SEARCH REPORT

0075028

International Application. No. PCT/JP82/00206

## I. CLASSIFICATION OF SUBJECT MATTER (If several classification symbols apply, indicate all) [3]

According to International Patent Classification (IPC) or to both National Classification and IPC

Int. Cl.[3] G03F7/00, G03D5/04

## II. FIELDS SEARCHED

### Minimum Documentation Searched [4]

| Classification System | Classification Symbols |
|---|---|
| I P C | G03F7/00 - 7/02, G03D 3/00 - 5/06 |

| | Documentation Searched other than Minimum Documentation to the Extent that such Documents are Included in the Fields Searched [5] |
|---|---|
| | Jitsuyo Shinan Koho 1926 - 1982 May |
| | Kokai Jitsuyo Shinan Koho 1971 - 1982 May |

## III. DOCUMENTS CONSIDERED TO BE RELEVANT [14]

| Category* | Citation of Document, [16] with indication, where appropriate, of the relevant passages [17] | Relevant to Claim No. [18] |
|---|---|---|
| X | JP,A, 51-5106 (Polychrome Corporation) 16. January. 1976 (16.01.76) & US,A, 3,916,426 & NL,A, 7,507,812 & DE, A1, 2,529,290 & FR,A1, 2,277,366 & GB,A, 1,506,408 | 1 |
| X | JP,U, 48-73001 (Toppan Printing Co., Ltd.) 12. September. 1973 (12.09.73) | 2 |
| X | JP,U, 54-151401 (Dainippon Screen Mfg. Co., Ltd.). 22. October. 1979 (22.10.79) | 2 |
| X | JP,U, 55-138647 (Dainippon Screen Mfg. Co., Ltd.) 2. October. 1980 (02.10.80) | 2 |

* Special categories of cited documents: [15]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search [2] | Date of Mailing of this International Search Report [2] |
|---|---|
| June 21, 1982 (21.06.82) | June 28, 1982 (28.06.82) |

| International Searching Authority [1] | Signature of Authorized Officer [20] |
|---|---|
| Japanese Patent Office | |

Form PCT ISA/210 (second sheet) (October 1981)